(19) Europäisches Patentamt
European Patent Office
Office européen des brevets

(11) Publication number: **0 644 597 A1**

(12) # EUROPEAN PATENT APPLICATION published in accordance with Art. 158(3) EPC

(21) Application number: **93913479.7**

(22) Date of filing: **03.06.93**

(86) International application number: **PCT/JP93/00750**

(87) International publication number: **WO 93/24958 (09.12.93 93/29)**

(51) Int. Cl.⁶: **H01L 27/10**, H01L 29/78

(30) Priority: **03.06.92 JP 170292/92**

(43) Date of publication of application: **22.03.95 Bulletin 95/12**

(84) Designated Contracting States: **DE GB NL**

(71) Applicant: **SHIBATA, Tadashi**
**5-2, Nihondairai,**
**Taihaku-ku**
**Sendai-shi,**
**Miyagi-ken 980 (JP)**
Applicant: **OHMI, Tadahiro**
**1-17-301, Komegabukuro 2-chome**
**Aoba-ku**
**Sendai-shi**
**Miyagi-ken 980 (JP)**

(72) Inventor: **SHIBATA, Tadashi**
**5-2, Nihondairai,**
**Taihaku-ku**
**Sendai-shi,**
**Miyagi-ken 980 (JP)**
Inventor: **OHMI, Tadahiro**
**1-17-301, Komegabukuro 2-chome**
**Aoba-ku**
**Sendai-shi**
**Miyagi-ken 980 (JP)**

(74) Representative: **Weitzel, Wolfgang, Dr.-Ing.**
**Patentanwalt**
**Friedenstrasse 10**
**D-89522 Heidenheim (DE)**

(54) **SEMICONDUCTOR DEVICE.**

(57) Using the title semiconductor device, a synapse circuit through which no steady-state current flows, whose positive and negative weights can be realized by a single 5-V current, and which has a self-learning function is realized. This semiconductor device comprises first and second power source lines which supply high and low two potentials a first NMOS having a first floating gate, and a second PMOS having a second floating gate. The source and drain of the first NMOS are connected to the second and first power source lines through third NMOS and fourth PMOS, respectively. The source and drain of the second PMOS are connected in the first and second power source lines through fifth PMOS and sixth NMOS, respectively. The sources of the first NMOS and second PMOS are connected to the thrid floating gate through first and second capacitors, respectively.

EP 0 644 597 A1

Fig. 1 (a)

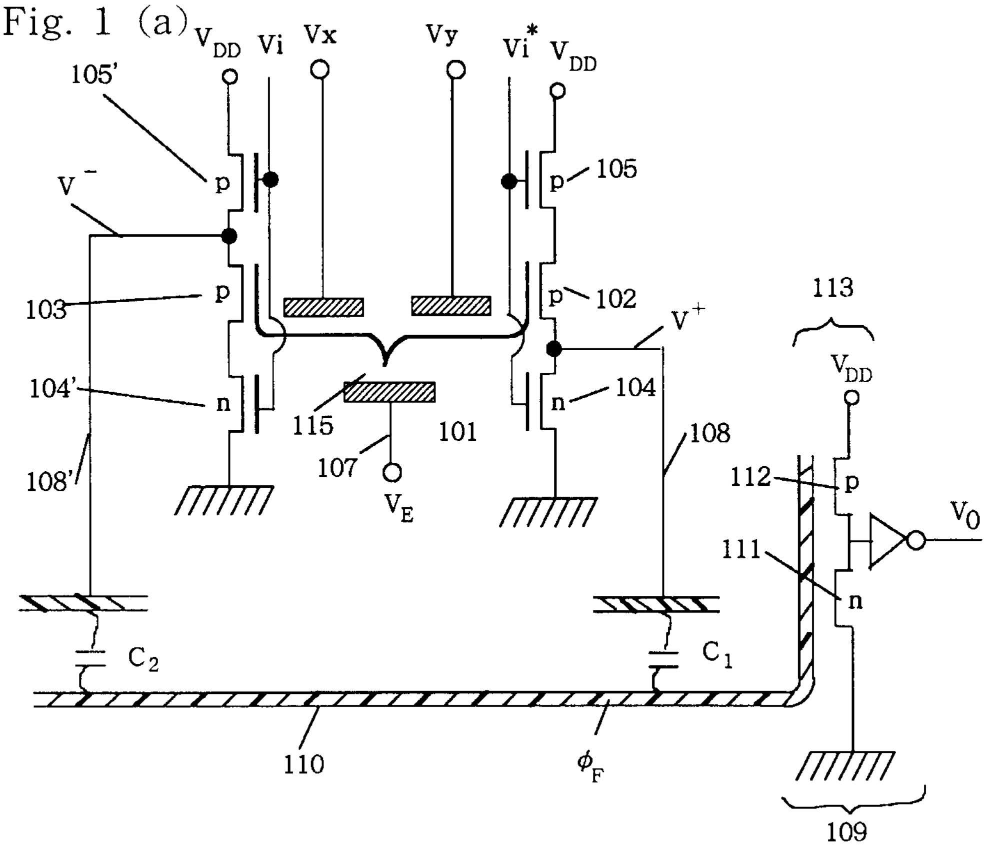
V_DD
Vi
Vx
Vy
Vi*
V_DD
105'
p
p
105
V⁻
103
p
p
102
V⁺
113
104'
n
115
n
104
V_DD
101
108
107
V_E
108'
112
p
V_0
111
n
C_2
C_1
110
φ_F
109

## Technical Field

The present invention relates to a semiconductor device, and in particular, relates to a semiconductor device which is applied to the construction of a high-performance neural network.

## Background Art

The pace of development in the integrated circuit technology of semiconductors has been surprisingly rapid, so that, for example, to use the example of dynamic memory, memories having a capacity of from 4 megabits to 16 megabits are already in mass production, and extremely high density memories having a capacity of 64 megabits or more are being developed at the research level. In 64 megabit memories, approximately 120,000,000 MOS transistors are integrated on a silicon chip which is, at most, 1 centimeter square. Such ultra-LSI technology has been applied not merely to memory circuits, but also to logic circuits, and various high-function logical integrated circuits, beginning with CPUs of from 32 bits to 64 bits, have been developed.

However, these logical circuits adopt a method in which operations are conducted using digital signals, that is to say, signals having one of the two values "1" and "0", so that, for example, in the case in which a computer is constructed therefrom, a method, termed the "Neumann method," is employed in which commands are executed one by one according to a program which is determined in advance. When such a method is employed, extremely rapid operations are possible with respect to simple numerical calculations; however, an extremely large amount of time is required for operations such as pattern recognition or image processing. Furthermore, such a method is extremely poor with respect to data processing at which human beings excel, such as association, learning, or the like, and presently, research into various types of software technologies is being conducted; however, the current state of affairs is such that rapid results are not being attained.

Here, in order to solve these problems, research has been conducted along a different line in which the functioning of the brains of animals has been studied, and attempts have been made to develop a computer which conducts operational processing in a manner which imitates such functioning, that is to say, to develop a neural circuit computer (neuron computer).

Such research began in the 1940s; however, in recent years, extremely active research has been conducted in the field. The reason for this is that in accordance with the progress in LSI technology, it has become possible to construct the hardware for such neuron computers.

However, there are still many problems with the realization of the neuron computer by means of LSI chips using current semiconductor LSI technology, and the current state of affairs is such that the goal of realizing such a computer has not yet been attained.

An explanation of where the technological problems lie in the realization of such a computer using LSI will be given hereinbelow.

The human brain has an extremely complex structure and has an extremely high degree of function; however, the basic composition thereof is extremely simple. That is to say, the brain comprises nerve cells (termed "neurons") possessing operational functions and neurofibrils, which serve to transmit the results of these operations to other neurons, or in other words, play the role of wiring.

A simplified model of the composition of the basic units of such a brain is shown in Fig. 6. Reference numerals 901a, 901b, and 901c indicate neurons, while references 902a, 902b, and 902c indicate neurofibrils. References 903a, 903b, and 903c are termed "synapse junctions"; they place, for example, a weight wa on a signal which is transmitted via neurofibril 902a, and input this into neuron 901a. Neuron 901a determines the linear sum of the signal strengths which are inputted into it, and if this total value is in excess of a threshold value, the nerve cell becomes active and outputs a signal to neurofibril 902b. If the total value is less than or equal to the threshold value, the neuron will not output a signal. When the total value reaches a threshold value or more, and the neuron outputs a signal, the neuron is said to "fire".

In an actual brain, these operations, such as the transmission of signals, weighting, and the like are conducted by means of electrochemical phenomena, and signals are transmitted and received as electrical signals. The process by which a human learns can be understood as a process in which the weighting in the synapse junctions is altered. That is to say, the weighting is gradually adjusted so as to obtain a correct output in response to a variety of combinations of input signals, and the weighting ultimately settles at the optimal value. That is to say, human intelligence is engraved in the brain as synapse weighting.

A large number of neurons are connected to one another via synapses and thus form one layer. It has been discovered that the human brain is formed of 6 of these layers. The realization of this type of structure and function as an LSI system using semiconductor devices is the most crucial problem in the realization of neuron computers.

Fig. 7(a) serves to explain the function of one nerve cell, that is to say, one neuron; this mathematical model was proposed in 1943 by McCulock and Pitts (Bull: Math. Biophys., vol. 5, p. 115 (1943)). Currently, as well, a large amount of research is being pursued along the lines of realizing this model as a semiconductor circuit and building a neuron computer. References $V_1$, $V_2$, $V_3$, ..., $V_n$ indicate a number n of input signals which are defined, for example, as voltage sizes; these correspond to signals which are transmitted from other neurons. References $w_1$, $w_2$, $w_3$, ..., $w_n$ indicate coefficients expressing the strength of the connection between neurons; in biological terms, they would be termed the "synapse junctions". The function of such a neuron is the operation in which a value of "1" is outputted when a value Z representing the linear summation of all inputs $V_i$, on which weights $w_i$ (i = 1 - n) have been placed, is greater than a pre-specified threshold value $V_{TH}^*$, and a value of "0" is outputted when Z is less than this threshold value. This can be expressed in formulas as shown below:

$$Z \equiv \sum_{i=1}^{n} W_i V_i \qquad (1)$$

$V_{out}$ = 1 ($Z > V_{TH}^*$)  (2)

0 ($Z < V_{TH}^*$)  (3)

Fig. 7(b) shows the relationship between Z and $V_{out}$;when Z is sufficiently larger than $V_{TH}^*$, a value of 1 is outputted, while when Z is sufficiently smaller than $V_{TH}^*$, a value of 0 is outputted.

When an attempt is made to realize such a neuron by means of a combination of transistors, a large number of transistors are required, and addition operations are conducted by converting each signal into a current value and causing these to complement one another, so that large currents flow and a large amount of power is consumed. Realization using LSI is thus impossible. This problem was solved by means of the invention (inventors: Tadashi Shibata and Tadahiro Ohmi, Japanese Patent Application No. Hei 1-141463) of a neuron MOSFET (abbreviated to νMOS).

This invention is capable of achieving the main functions of the operation of a neuron by means of only one transistor, and moreover, is capable of adding the voltage signals in an unchanged manner, so that it is an epoch-making invention in which there is almost no power consumption. Fig. 8(a) shows a simplified example of the cross-sectional structure of such an νMOS; reference numeral 1101 indicates, for example, a P-type silicon substrate, reference numerals 1102 and 1103 indicate a source and a drain formed by means of $N^+$ diffused layers, reference numeral 1104 indicates a gate insulating film (for example, $SiO_2$ or the like) which is provided on the channel region, reference numeral 1106 indicates a floating gate which is electrically insulated and is placed in a floating state with respect to potential, reference numeral 1107 indicates an insulating film, such as, for example, $SiO_2$ or the like, and reference numeral 1108 ($G_1$, $G_2$, $G_3$, $G_4$) is an input gate and corresponds to the inputs of the neuron.

Fig. 8(b) shows the same structure in a simplified form in order to explain the operation thereof. If the capacity coupling coefficient between each input gate and the floating gate is represented by $C_G$, and the capacity coupling coefficient between the floating gate and the silicon substrate is represented by $C_0$, then the potential Z of the floating gate is represented by:

$Z = -w (V_1 + V_2 + V_3 + V_4)$  (4)

$W \equiv C_G / (C_0 + 4C_G)$  (5)

Here, $V_1$, $V_2$, $V_3$, and $V_4$ indicate voltages which are inputted into input gates $G_1$, $G_2$, $G_3$, and $G_4$, respectively, and the potential of the silicon substrate is 0V, so that it is, in other words, grounded.

If the floating gate is viewed as the gate electrode, this νMOS comprises a N-channel MOS transistor, and if the threshold voltage (the voltage at which an inversion layer is produced at the substrate surface) from the point of view of the floating gate is represented by $V_{TH}^*$, then when $Z > V_{TH}^*$, the νMOS described above is in an ON state, while when $Z < V_{TH}^*$, it is in an OFF state. In other words, if, for example, an inverter circuit such as that shown in Fig. 8(c) is constructed using one such νMOS 1109, it is possible to express the function of one neuron in a simple manner. Reference numerals 1110 and 1111 indicate resistors used to construct the inverter, and reference 1112 indicates an NMOS transistor. Fig. 8(d) shows

$V_{out1}$ and $V_{out2}$ as a function of Z; with respect to an input such that $Z > V_{TH}^*$, $V_{out2}$ is outputted at the high-level voltage $V_{DD}$. In other words, a state is realized in which the neuron fires.

The basic operation in which, as shown in Formula (4), the inputs into the neuron are added as voltage levels, and when the linear sum thereof is equal to or greater than the threshold value, the neuron fires, can be realized by means of a single νMOS. Voltage-mode addition is conducted, so that the current flowing in the input portion is only the charge and discharge current of the capacitor, and the size thereof is extremely small. On the other hand, in the inverter, a direct current flows when the neuron fires; however, this is because resistor 1110 is used as a load, but if a νMOS gate having a CMOS structure in accordance with this invention (Japanese Patent Application No. Hei 1-141463) is used, it is possible to eliminate this direct current.

Fig. 9 shows an example of this CMOS structure. Fig. 9(a) shows a model of the cross-sectional structure of an CMOS neuron gate; reference numeral 1201 indicates a P-type silicon substrate, reference numeral 1202 indicates an n-type well, reference numerals 1203a and 1203b indicate, respectively, a $N^+$-type source and drain, reference numerals 1204a and 1204b indicate, respectively, a $P^+$-type source and drain, reference numeral 1205 indicates a floating gate, and reference numerals 1206a ~ 1206d indicate, respectively, input gate electrodes. Reference numerals 1207 and 1208 indicate insulating films of, for example, $SiO_2$ or the like, and reference numeral 1209 indicates a field oxide film. Fig. 9(b) shows an example in which one neuron circuit is constructed; reference numeral 1210 is applied to the CMOS floating gate of Fig. 9(a), and the parts to which references are applied correspond to the references in Fig. 9(a). Reference numeral 1211 indicates an CMOS inverter, and reference numerals 1212 and 1213 indicate, respectively, NMOS and PMOS transistors. Furthermore, reference numeral 1214 indicates the output of the neuron.

As described above, it is possible to construct a neuron using a small number of elements, and moreover, the power consumption is extremely small, so that the νMOS is an indispensable element for the realization of a neuron computer.

However, in order to realize a neuron computer, it is necessary to construct one crucial element other than the neuron; that is to say, the synapse. Fig. 10 shows an example of the basic structure of a neuron circuit including synapse junctions constructed by means of the conventional technology.

Reference numeral 1301 indicates a neuron circuit such as that shown, for example, in Fig. 8(c), and reference numeral 1302 indicates wiring which transmits an output signal from another neuron. Reference numeral 1303 indicates the synapse junction circuit; this circuit is for the purpose of applying weights to input signals. This circuit is a source-follower circuit in which a load resistance $(R + R_x)$ is connected to the source 1306 of an NMOS transistor 1304. Accordingly, when the output voltage Vs of a neuron which has fired is applied to the gate electrode 1305 of the NMOS transistor, a voltage of $V_s - V_{TH}$ is outputted in source 1306 (here, $V_{TH}$ indicates the threshold voltage of the NMOS transistor 1304).

For example, if an MOS transistor in which $V_{TH} = 0$ is employed, the potential of the source 1306 is equivalent to $V_s$, and this voltage is divided over the two resistors R and $R_x$, becoming the output voltage of the synapse junction circuit, and is transmitted by means of connection 1307 to neuron 1301. This output voltage is $V_S \cdot R_x / (R + R_x)$, and thus a weight of $R_x / (R + R_x)$ is applied to signal voltage $V_S$. By making the value of Rx variable, it is possible to alter the weighting.

Fig. 11(a) shows an example of a method for the realization of a variable resistor. For example, if a constant voltage $V_{GG}$ is applied to the gate of one MOS transistor 1401, then this transistor will function as a resistor. By means of altering the value of $V_{GG}$, it is possible to vary the resistance value.

Furthermore, Fig. 11(b) shows an example of a circuit which controls the value of $V_{GG}$; it comprises a 4-bit binary counter 1402 and a D/A converter 1403. The connection strength of the synapse is represented as a 4-bit binary number, and this is converted to an analog voltage by means of D/A converter 1403 and outputted as the value of $V_{GG}$. In order to increase the synapse connection strength, the value of the counter may be counted down by means of a control signal, and the value of $V_{GG}$ reduced.In the opposite case, when the synapse connection strength is to be reduced, the value may be counted up, and the value of $V_{GG}$ increased.

The problems involved when a synapse junction circuit such as that shown in Figs. 10 and 11 is used will be explained in the following.

The first problem is that in order to generate the weighting in Fig. 10, a voltage division by means of resistors is used. In accordance with this method, a current is constantly passed to these resistors, and thereby a weighted output voltage is maintained, so that power equivalent to $V_S^2 / (R + R_x)$ is constantly consumed. As a result of this, even if the power consumption in neuron 1301 were reduced by means of the application of a νMOS, the power consumption of the circuit as a whole would certainly not be small. If a 2-layered neural circuit network in which one layer comprises a number of neurons n is considered, the number of synapse junctions will be $n^2$, and thus the number of synapses will be vastly greater than the number of neurons. Accordingly, to the extent that synapse junction circuits which constantly require a current flow are employed, the power consumption of a neural circuit network of a scale suited to application will become excessive, and such a network will be impossible to design in practice. The power consumption can be reduced by setting the value of $R + R_x$ to a sufficiently large value; however, in such a case, the time constant required to charge and discharge $C_{out}$ becomes extremely large, and the speed of operation of the synapse circuit decreases markedly.

The second problem is the fact that the circuit shown in Fig. 11(b), which determines the weight of the matter of the connections, requires a large number of elements and cannot be integrated. In order to construct a neural circuit network possessing a learning function, it is necessary that the strength of each synapse junction can be appropriately altered, and that these altered values be stored. In the Figure, a 4-bit binary counter was used for this purpose; however, at least 30 MOS transistors are necessary for this alone. Furthermore, a large number of elements are necessary to construct the D/A converter. Furthermore, this circuit also consumes a large amount of power per synapse junction, and is thus disadvantageous from the point of view of power consumption, as well.

A method in which a non-volatile memory of a floating gate-type EPROM or $E^2$PROM is used has been proposed as a method for the reduction of the number of elements necessary for the construction of a synapse. These devices have threshold values which vary in accordance with the amount of charge within the floating gate, so that they are capable of storing weights in an analog manner in accordance with the amount of charge. The individual synapse circuits which serve to store the weights of one transistor can be made smaller in comparison with the circuit shown in Fig. 11(b). However, in order to read this out as a weight, and multiply it by the output of the neuron of the previous stage, a correspondingly complex circuit is necessary. For example, a differential amplifier is constructed using 2 $E^2$PROM memory cells (D. Soo and R. Meyer, "A Four-Quadrant NMOS Analogue Multiplier", IEEE J. Solid-state Circuits, vol. sc-17, no. 6, December 1982), and a weighted result is read out as a current signal. A large-scale simplification of the circuit cannot be achieved, and weighting is conducted by means of a constant current flow, so that the power consumption is extremely large, and thus such a method cannot be employed in the construction of a large-scale neural network.

A further important problem is shown in Fig. 12.

Fig. 12(a) shows the threshold voltage ($V_{TH}$) of the $E^2$PROM cell using a tunnel junction, as a function of the number of pulses for data writing. The program voltage is 19.5 V, and the pulse width is 5 msec. When a positive pulse is applied to the control electrode for the program, electrons are implanted in the floating gate and the threshold value is shifted in the positive direction. In the opposite case, when a negative pulse is applied, electrons are released from the floating gate, and the threshold value is shifted in the negative direction. As can be understood from the Figure, as a result of the initial pulse, the threshold value is shifted greatly, and as a result of following pulses, only an extremely small change is effected. Using this, it is impossible to finely vary the threshold value and adjust the synapse weighting at many levels.

The reason for this can be explained as follows.

Fig. 12(b) shows the state of the change over time of the number (n) of electrons implanted in the floating gate during the application of a positive program voltage as a step function. It can be seen that in the initial stage of voltage application, numerous electrons are implanted, and that this number shows almost no increase thereinafter. This forms the basis of charge implantation. This is because the current flowing through the insulating film, termed "Fowler-Nordheim Tunneling", depends on the potential difference V between the ends of the insulating film, in accordance with the following formula:

$$I \propto V^2 \exp(-b / V)$$

That is to say, when the number of electrons in the floating gate increases as a result of the initial tunnel current, the floating gate potential decreases as a result of this, and V becomes smaller, and as a result, the tunnel current is exponentially reduced. In order to control the tunnel current at a fixed value, and to accurately alter the synapse weighting, it is necessary to accurately control the size of the pulse voltage or the pulse width in accordance with the number of the charge within the floating gate, and furthermore, this results in the necessity for a large number of circuits.

In short, it must be said that with the conventionally-known technology, the construction of a neural circuit network was essentially impossible from the point of view of lowering the amount of power consumed, shifting to large-scale integration, and the accuracy of synapse weighting. Accordingly, it was impossible to realize a neuron computer using conventional technology.

Furthermore, it is necessary that the synapse be able to realize negative and positive weighting.

Conventionally, in order to realize such negative weighting, a negative power source of, for example, $-V_{DD}$ (-5 V) was necessary in addition to the ground and the $V_{DD}$ (+5 V) line. Increasing the number of power sources is not desirable in an LSI system, and the realization of a chip which operated, insofar as possible, with a single 5 V power source has been strongly desired; however, such circuitry does not yet exist. Furthermore, it is necessary that the weighting can be freely altered while being stored.

An example of a conventional synapse circuit will be explained in accordance with Fig. 5.

The Figure shows a synapse circuit using EEPROM cells which were announced in 1990 by M. Holler, et al.

In the Figure, reference numerals 1 and 2 indicate current sources, the current values of which are determined by the potentials written in $E^2$PROM cells 3 and 4, respectively. Reference numerals 5 and 6 indicate differential amplifiers, in which the difference between current values flowing to input terminals 7 and 7', or 8 and 8', is determined by the difference $\Delta V_{IN}$ between the two input voltages. The difference between the currents $I^+$ and $I^-$ which flow to output lines 9 and 9' is given by the following formulas.

$$\Delta I = I^+ - I^-$$
$$= A\Delta V_{IN} \cdot \Delta V_{FG}$$

Here, A indicates a proportional constant. If $\Delta V_{IN}$ represents the output of the previous-stage neuron, $\Delta V_{FG}$ indicates the weight of the synapse, and $\Delta I$ indicates the output of this synapse, then the result of the synapse weight multiplied by the output of the previous stage neuron becomes the output of the synapse, and the synapse function is satisfactorily realized.

However, this synapse circuit operates in current-mode, and a current constantly flows during circuit operation. Accordingly, the power consumption is large, so that large-scale integration is impossible. In this state of affairs, a voltage mode synapse circuit which is capable of realizing synapse weighting without a steady-state current has been strongly desired.

In consideration of the above circumstances, the present invention has as an object thereof to provide a semiconductor device which is capable of realizing a synapse circuit which: (1) employs absolutely no steady-state current, (2) is capable of realizing positive and negative weighting using a single 5 V current, and moreover, (3) possesses a self-learning function.

## Disclosure of the Invention

The semiconductor device in accordance with the present invention is characterized in that it is provided with: first and second power source lines, which supply two potentials, a high-level and a low-level potential, respectively; a N-channel-type first MOS transistor possessing a first floating gate; and a P-channel-type second MOS transistor possessing a second floating gate; and in that the source and drain of the first MOS transistor are connected to the second and first power source lines, respectively, via a N-channel-type third MOS transistor and a P-channel-type fourth MOS transistor, respectively; the source and drain of the second MOS transistor are connected to the first and second power source lines, respectively, via a P-channel-type fifth MOS transistor and a N-channel-type sixth MOS transistor, respectively; and the sources of the first and second MOS transistors are connected with a third floating gate via first and second capacitors, respectively.

## Function

The semiconductor device in accordance with the present invention allows the realization of a synapse circuit which employs no steady-state current, is capable of realizing both positive and negative weighting using a single 5 V current, and possesses a self-learning function, so that the realization of a large-scale neural network becomes possible for the first time.

## Brief Description of the Drawings

Fig. 1 is a circuit diagram explaining a first example of the present invention.
Fig. 2 is a circuit diagram explaining a second example of the present invention.
Fig. 3 is a circuit diagram explaining a third example of the present invention.

Fig. 4 is a circuit diagram explaining a fourth example of the present invention.

Fig. 5 is a circuit diagram showing a conventional synapse circuit.

Fig. 6 is a diagram of a model of the structure of a basic unit of the brain.

Fig. 7(a) is a schematic diagram explaining the function of a single nerve cell, that is, a single neuron.

Fig. 7(b) is a graph showing the relationship between Z and $V_{out}$.

Fig. 8(a) is a simplified schematic diagram showing an example of νMOS structure.

Fig. 8(b) is a more simplified diagram showing the structure in Fig. 8(a).

Fig. 8(c) is a circuit diagram of an inverter using the neuron element of Fig. 8(a).

Fig. 8(d) is a graph showing $V_{out}$ and $V_{in}$ in the circuit of Fig. 8(c) as a function of Z.

Fig. 9(a) shows the cross sectional structure of a CMOS neuron gate in the form of a model.

Fig. 9(b) is a circuit diagram showing the composition of one neuron circuit.

Fig. 10 is a circuit diagram showing an example of the basic composition of a neuron circuit containing a synapse circuit using a νMOS transistor in accordance with the conventional technology.

Fig. 11(a) is a circuit diagram showing an example of a method for the realization of a variable resistor.

Fig. 11(b) is a circuit diagram showing an example of the control of the value of $V_{GG}$.

Fig. 12(a) is a graph showing the threshold voltage ($V_{TH}$) in an $E^2$PROM cell using a tunnel junction, as a function of the number of pulses for data writing.

Fig. 12(b) is a graph showing the state of the change over time in the number (n) of electrons injected into the floating gate during the application of a positive program voltage as a step function.

(Description of the References)

| | |
|---|---|
| 101 | floating gate |
| 102, 111 | N-channel νMOS |
| 103, 112 | P-channel νMOS |
| 104, 104' | NMOS transistors |
| 105, 105' | PMOS transistors |
| 107 | writing electrode ($V_E$ electrode) |
| 106 | $V_x$ electrode |
| 106' | $V_y$ electrode |
| 108, 108' | output terminals |
| 109 | following-stage neuron |
| 110 | floating gate of neuron 109 |
| 112 | P-channel νMOS |
| 113 | CMOS νMOS inverter |
| 114 | inverter |
| 901a, 901b, 901c | neurons |
| 902a, 902b, 902c | neurofibrils |
| 903a, 903b, 903c | synapse junctions |
| 1101 | silicon substrate |
| 1102, 1103 | source and drain |
| 1104 | gate-insulating film |
| 1106 | floating gate |
| 1107 | insulating film |
| 1108 | input gate |
| 1110, 1111 | resistors for constructing an inverter |
| 1112 | NMOS transistor |
| 1201 | silicon substrate |
| 1202 | well |
| 1203a | source |
| 1203b | drain |
| 1204a | source |
| 1204b | drain |
| 1205 | floating gate |
| 1206a ~ d | electrodes of the input gate |
| 1207, 1208 | insulating films |
| 1209 | field oxide film |
| 1210 | CMOS neuron gate |

| | |
|---|---|
| 1211 | CMOS inverter |
| 1212 | NMOS transistor |
| 1213 | PMOS transistor |
| 1214 | output terminal of neuron circuit |
| 1301 | neuron circuit |
| 1302 | wiring transmitting output signals of other neurons |
| 1303 | synapse junction circuit |
| 1304 | NMOS transistor |
| 1305 | gate electrode |
| 1306 | source |
| 1307 | connector |
| 1401 | MOS transistor |
| 1402 | binary counter |
| 1403 | D/A converter |

**Best Mode for Carrying Out the Invention**

(Embodiment 1)

A first embodiment of the present invention is shown in Fig. 1(a). In the Figure, $V_i$ indicates an output signal from a previous-stage neuron, and in accordance with the firing or non-firing of this neuron, $V_i$ has a value of $V_{DD}$ or 0 V.

$V_i^*$ represents the inversion signal thereof. Reference numeral 101 indicates a floating gate, which forms the gate electrode of NMOS 102 and PMOS 103. Reference numerals 104 and 104' indicate NMOS transistors, while reference numerals 105 and 105' indicate PMOS transistors. References $V_x$ and $V_y$ indicate input gates for determining the potential of floating gate 101, and reference $V_E$ indicates a writing electrode for conducting the sending and receiving of charge. A $SiO_2$ film having a thickness of, for example, 100 Å is formed between floating gate 101 and writing electrode 107, and when the difference in potential between these two is sufficiently large, for example, approximately 10 V, a current flows as a result of the Fowler-Nordheim Tunneling Effect, and the amount of charge $Q_F$ in the floating gate changes. Here, if the potential of the floating gate is represented by $\phi_F{}^S$, then

$$\phi_F{}^S = (C_xV_x + C_YV_y + C_E + Q_F) / (C_x + C_y + C_E + C_0) \qquad (6)$$

Here, $C_x$ and $C_y$ indicate capacity coupling coefficients between floating gate 101 and $V_x$ electrode 106 and $V_y$ electrode 106', respectively, reference $C_E$ indicates the capacity coupling coefficient between $V_E$ electrode 107 and the floating gate, and reference $C_0$ indicates the floating capacity. References $V^+$ and $V^-$ indicate output voltages present in the two output terminals 108 and 108' of the circuit, respectively; these are capacitively coupled with the floating gate 110 of the following-stage neuron 109 via capacitors $C_1$ and $C_2$. Reference 109 indicates a neuron circuit; this comprises a normal inverter 114 and a CMOS$\nu$MOS inverter (113) comprising, for example, a N-channel neuron MOS transistor ($\nu$MOS) 111 and a P-channel $\nu$MOS 112. Reference $V_0$ indicates the output of the neuron circuit; in the circuit, if the potential of the floating gate 110 of the neuron is represented by $\phi_F$, then when $\phi_F > V_{TH}{}^*$, then $V_0 = 1$, while when $\phi_F < V_{TH}{}^*$, then $V_0 = 0$.

Next, the operation of this circuit will be explained. First, when the previous-stage neuron does not fire, that is to say, when $V_i = 0$ ($V_i^* = V_{DD}$), NMOS and 104' and PMOS 105 are placed in an OFF state, NMOS 104 and PMOS 105' are placed in an ON state, and the circuit is equivalent to that shown in Fig. 1(b). As output terminals 108 and 104' are directly connected to grounds (0 V) and $V_{DD}$, respectively, they have values of 0 and $V_{DD}$, respectively. On the other hand, when the previous-stage neuron fires, NMOS 104' and PMOS 105 are placed in an ON state, NMOS 104 and PMOS 105' are placed in an OFF state, and the circuit is equivalent to that shown in Fig. 1(c). At this time, a current is passed from power source $V_{DD}$ to the $V^+$ terminal via NMOS transistor 102, so that the potential increases, and this increase continues until the NMOS transistor enters an OFF state. Accordingly, the final value thereof is $\phi_F{}^S - V_{TH}{}^*$. Here, $V_{TH}{}^*$ indicates the threshold voltage from the point of view of the floating gate of the NMOS. Furthermore, the $V^-$ terminal is discharged via PMOS 103, and the potential is reduced, so that the final value thereof is $\phi_{FS} - V_{TP}{}^*$. Here, $V_{TP}{}^*$ represents the threshold value as viewed from the floating gate of the PMOS.

The state of the change in relaxation of $V^+$ and $V^-$ after the previous-stage neuron has fired when $t = t_1$ is shown in Fig. 1(d).

$V^+$ and $V^-$ are coupled with the floating gate 110 of the following-stage neuron via capacitors $C_1$ and $C_2$, respectively, so that has the same effect as if a potential $V_{EFF}$ were applied via one capacitor $C_1 + C_2$ - (see Fig. 1(e)). Here, $V_{EFF}$ is given by the following formula.

$V_{EFF} = (C_1 V^+ + C_2 V^-) / (C_1 + C_2)$ (7)

In the present Embodiment, because these values are set such that $C_1 = C_2 = C/2$, then the following relationship obtains:

$V_{EFF} = (V^+ + V^-) / 2$ (8),

and this is equivalent to the situation in which this potential is coupled with floating gate 110 via a capacitor having a size C.

The change over time in $V_{EFF}$ is shown in Fig. 1(d). To sum up the above, when the previous-stage neuron does not fire ($V_i = 0$), then the circuit of Fig. 1(a) outputs

$V_{EFF} = V_{DD} / 2$,

and when the neuron fires (when $V_i = V_{DD}$), then this synapse circuit outputs:

$V_{EFF} = \{2\phi_F{}^S - (V_{Tn}{}^* + V_{Tp}{}^*)\} / 2$

In particular, this circuit is a synapse circuit which, in the case in which $V_{Tn}{}^* = |V_{Tp}{}^*|$ ($V_{Tp}{}^* < 0$), outputs

$V_{EFF} = \phi_F{}^S$

Fig. 1(f) represents the state in which a neuron 109 is coupled with the outputs $V_1$, $V_2$, ..., $V_n$ of a number n of neurons via identical synapse circuits $S_1$, $S_2$, ..., $S_n$, represented in a type diagram. The floating gate potential $\phi_F$ of the neuron 109 at this time is given by the following formulae.

$$\phi_F = \sum_{i=1}^{n} (C\ C_{TOT})\ [\phi_F{}^S\ (V_i\ V_{DD}) + (V_{DD}\ 2)\ \{1 - (V_i\ V_{DD})\}]$$
$$= \sum_{i=1}^{n} (C\ C_{TOT})\ \{\phi_F{}^S - (V_{DD}\ 2)\}\ (V_i\ V_{DD}) + (nC\ C_{TOT})\ (V_{DD}\ 2)$$

(9)

When $C_{TOT} = nC$, then

$$\phi_F = \sum_{i=1}^{n} (1/n)\ (\phi_F{}^S / V_{DD} - 1/2)\ V_i + V_{DD} / 2 \qquad (10)$$

Accordingly, the weighting of each synapse can be effectively represented as follows:

$W_i = (1 / n) (\phi_F{}^S / V_{DD} - 1 / 2)$ (11)

When $\phi_F{}^S > (1 / 2)$ and $W_i > 0$, this results in an excited synapse junction, while when $\phi_F{}^S < 1/2$ and Wi $< 0$, then a suppressed synapse results. $\phi_F{}^S$ is given by Formula (6), so that, for example, if $V_x = V_y = V_E$

= 0, then the following results:

$\phi_F{}^S = Q / C_{TOT}$ (12)
$(C_{TOT} = C_x + C_y + C_E + C_0)$,

and the value of $\phi_F{}^S$, that is to say, the value of $W_i$, can be set to any desired positive or negative value by means of the value of $Q_F$.

For example, if conditions are set such that $V_x = V_E = V_{DD}$, $V_y = 0$, and $C_X + C_E = (1 / 2) C_{TOT}$, then from Formulae (6) and (11), $W_i$ has the following value:

$W_i = (1 / n) (Q_F / C_{TOT}V_{DD})$ (13)

and the positive or negative value of $Q_F$ determines the positivity or negativity of $W_i$. That is to say, in the present synapse circuit, it is possible to establish a positive or negative charge value solely by means of the single power source voltage $V_{DD}$. Furthermore, as is clear from Figs. 1(b) and (c), the so-called "through-current", in which all transistors are set to an OFF state irrespective of the firing or non-firing of the previous-stage neuron, does not flow in a steady-state manner. Accordingly, little power is consumed, and this is ideal for large-scale integration.

Next, a discussion will be conducted with respect to the method for changing the value of the charge $Q_F{}^S$ in the floating gate 101. For example, in Formula (6), $C_x$ is set equal to $C_y$, and for the purposes of simplicity, as $C_E$ and Co << $C_X$ and $C_y$, conditions are set such that $C_E = C_0 = 0$, so that these can be ignored. Furthermore, if it is assumed that $Q_F = 0$, then when $V_x = V_y = V_{PP}$, $\phi_F{}^S = V_{PP}$ results; however, when either of $V_x$ or $V_y$ has a value of 0 V, then $\phi_F{}^S = V_{PP} / 2$ results. Furthermore, when $V_x = V_y = 0$, then it is clear that $\phi_F{}^S = 0$ results. Accordingly, only in synapses in which $V_x = V_y = V_{PP}$ and $V_E = 0$ does the program voltage $V_{PP}$ (for example, 10 V) operate in tunnel oxide film portion 115, so that tunneling is generated, electrons are implanted in the floating gate, and $\Delta Q_F < 0$ results. In other cells, tunneling does not occur. The reason for this is that a Fowler-Nordheim Tunnel Current decreases exponentially with respect to voltage (electric field) so that such a current does not flow at (1/2) $V_{PP}$.Electron discharge only occurs at synapses in which $V_x = V_y = 0$ and $V_E = V_{PP}$.

For example, it is possible to dispose $V_x$ and $V_y$ and the wiring running in the x-direction and the y-direction, and to reduce the weight only in the synapse positioned at the intersection of the wiring to which the potential of $V_{PP}$ is applied, or to increase the weight only at the synapse positioned at the intersection of the wiring to which 0 V is applied. At this time, $V_E$ is the same throughout the chip (see Fig. 1(g)).

For example, the $V_x$ line in which $V_x = V_{PP}$ is a $V_x$ line corresponding to a neuron which should have outputted a value of 0, but rather erroneously outputted a value of 1. Furthermore, the only $V_y$ line in which $V_y = V_{PP}$ is a $V_y$ line corresponding to a previous-stage neuron which has fired.

In this manner, it is possible to selectively implant electrons and lower the weight of a synapse into which a value of 1 was inputted with respect to a neuron which erroneously outputted a value of 1, and the firing of which was thus aided. That is to say, learning in accordance with Hebb's rules can be realized in terms of hardware. Conventionally, neural net learning was conducted by conducting calculations based on complicated learning rules by means of an external large computer, and based on the results of these calculations, rewriting the contents of $E^2$PROMs one by one, so that an enormous amount of time was required for such learning; however, in accordance with the present invention, it is possible to greatly shorten the learning time.

When the strengthening or weakening of selected synapse junctions is carried out, the setting of the values of $V_x$, $V_y$, $V_E$, and the like in such a manner that mistakes are not produced in the data writing is important.

(Embodiment 2)

Fig. 2 explains a second embodiment of the present invention; it is a time chart showing the timing of the installation of $V_x$ and $V_y$ in a neural network having a timing circuit for the prevention of writing errors.

In short, after the setting of all synapses such that $V_E = (1/2) V_{DD}$, only predetermined $V_x$ and $V_y$ are set to $V_{DD}$. It is possible to conduct the implantation or discharge of electrons by setting $V_E$ in the manner of a pulse to either $V_{DD}$ or 0, respectively. By proceeding in this manner, the voltage operating in the tunnel portions of all synapses will be equal to or less than (1/2) $V_{DD}$ at all times other than during data writing, so that erroneous operation does not occur.

(Embodiment 3)

Fig. 3 shows a third embodiment of the present invention.

Resistors R are connected between the floating gate 301 of the charge implantation unit and the floating gate of the transistor. These resistors R are set to values sufficiently larger than the effective resistance values during the tunnel current flow in the tunnel portion, and thereby, it is possible to essentially standardize the number of electrons which are implanted (or discharged) during each pulse. This is extremely effective for the precise alteration of weighting.

(Embodiment 4)

Fig. 4 is a circuit diagram showing a fourth embodiment.

The points of difference between this embodiment and that of Fig. 1 are that floating gate 101 is partitioned into independent floating gates 401 and 402, and that $V_i$ does not represent the output of the previous-stage neuron, but the clock signal of the system. Furthermore, floating gate 403 does not necessarily have to be the output of a neuron, but rather the floating gate of a common neuron MOS transistor.

The circuit is such that when the clock signal has a value of 0, (1/2) $V_{DD}$ is outputted as $V_{EFF}$, and when the clock reaches $V_{DD}$, then the following is outputted:

$$1/2 \{\sum_{i=1}^{n} (C_i / C_{TOT}) V_i + \sum_{j=1}^{m} (C_j' / C_{TOT}) V_j'\}$$

In comparison with a conventional inverted CMOS-type circuit, not only is there absolutely no power consumption, but the period of time required for the final settling of the output is shorter.

In the foregoing, discussion centered only on the case in which $V_{Tn}^* > 0$, $V_{TP}^* < 0$, and both the floating gate-type NMOS and PMOS were of the enhancement type; however, both of these may be of the depression-type as well. Furthermore, it is of course the case that depending on use, one may be of the depression-type while the other may be of the enhancement-type. Furthermore, $V_{Tn}^* = V_{TP}^* = 0$ is also possible.

Furthermore, discussion centered on only the case in which all floating gates were floating; however, these may also be suitably connected to appropriate potentials via switching transistors. By proceeding in this manner, it is possible to directly apply the necessary charge and to effectively change the threshold value from the point of view of the floating gate. Furthermore, the resistors employed in the third embodiment are thin-film transistors, and the gates thereof may be placed in an OFF state, only during data writing, so that they have a high resistance.

## Industrial Applicability

In accordance with the present invention, it is possible to realize a synapse circuit which is capable of realizing positive and negative weighting by means of a single 5 V current with absolutely no use of a steady-state current, which synapse circuit possesses a self-learning function, so that it becomes possible for the first time to realize a large-scale neural network.

## Claims

**1.** A semiconductor device, characterized in being provided with: first and second power source lines which supply, respectively, two potentials, a high-level and a low-level potential; a N-channel-type first MOS transistor possessing a first floating gate; and a P-channel-type second MOS transistor possessing a second floating gate; and in that a source and drain of said first MOS transistor are connected to said second and first power source lines, respectively, via a N-channel-type third MOS transistor and a P-channel-type fourth MOS transistor, respectively; a source and drain of said second MOS transistor are connected to said first and second power source lines, respectively, via a P-channel-type fifth MOS transistor and a N-channel-type sixth MOS transistor, respectively; and sources of said first and second MOS transistors are connected to a third floating gate via first and second capacitors, respectively.

2. A semiconductor device in accordance with claim 1, characterized in that said first and second floating gates are electrically connected.

3. A semiconductor device in accordance with one of claims 1 and 2, characterized in that at least one of said first, second, or third floating gates is connected to a signal line supplying a pre-specified potential via a MOS transistor.

4. A semiconductor device in accordance with one of claims 1 through 3, characterized in that gate electrodes of said third and fourth MOS transistors are mutually connected, and gate electrodes of said fifth and sixth MOS transistors are mutually connected.

5. A semiconductor device in accordance with one of claims 1 through 4, characterized in that binary signals applied to gates of said third and fourth MOS transistors are in an inverse relationship with binary signals applied to gates of said fifth and sixth MOS transistors.

Fig. 1 (a)

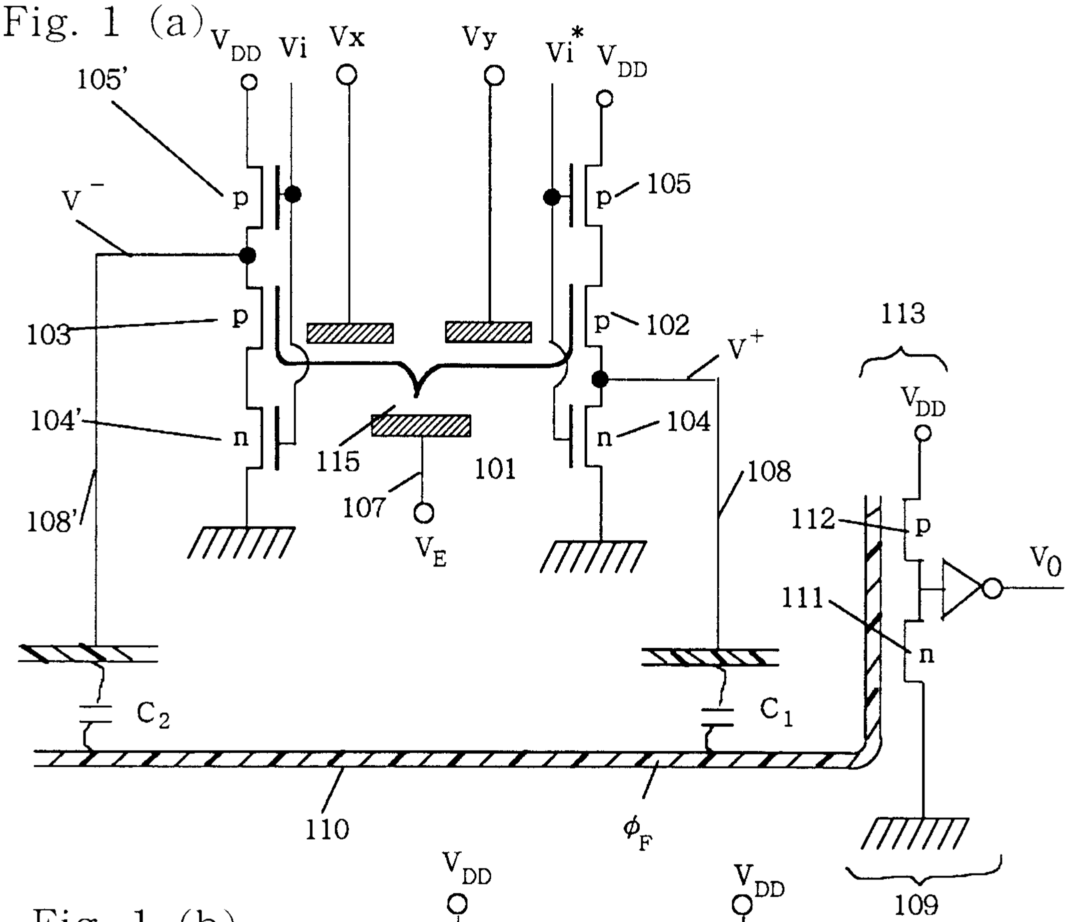


Fig. 1 (b)

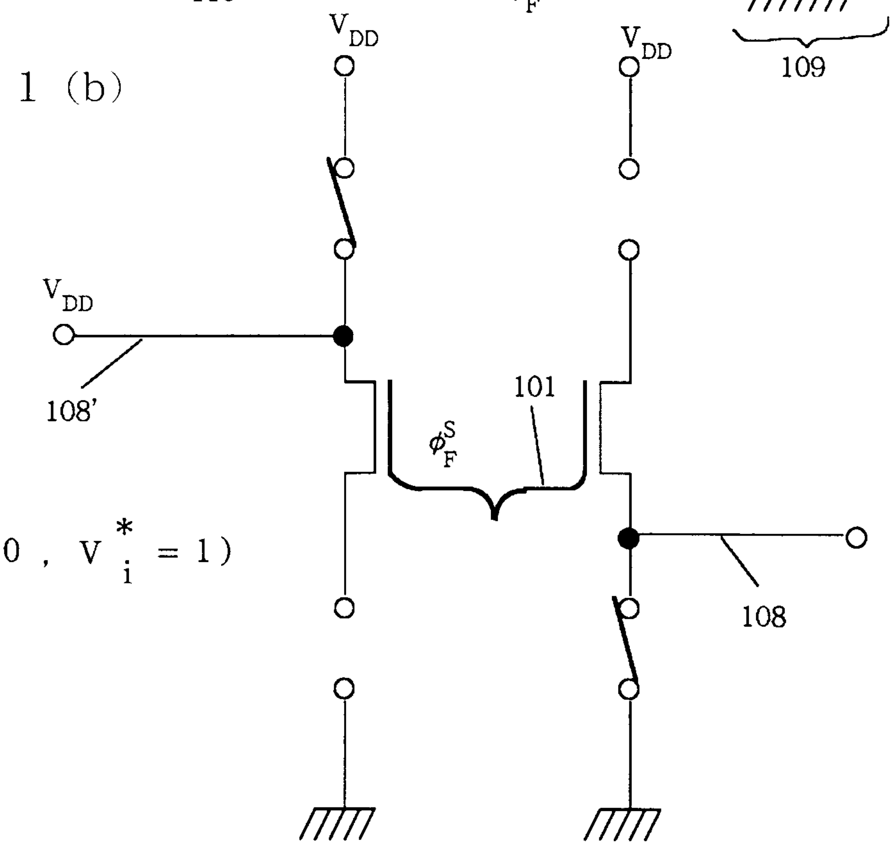


$(V_i = 0\ ,\ V_i^* = 1)$

Fig. 1 (c)

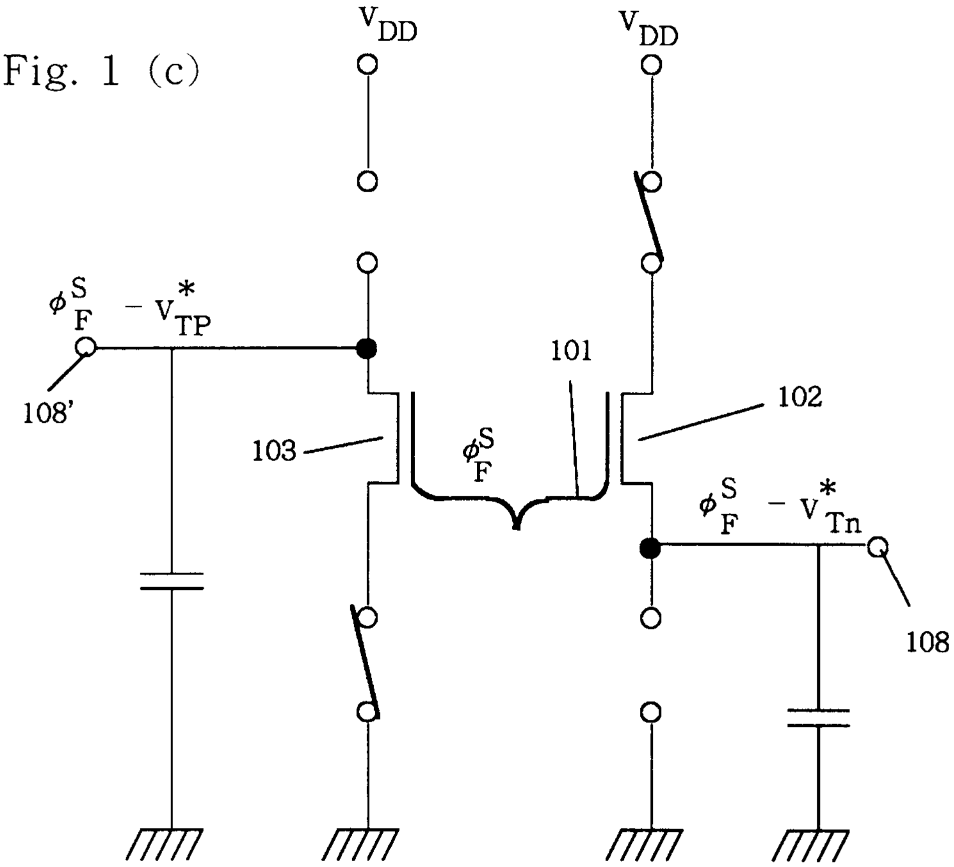


Fig. 1 (d)

(Vi = 1 , Vi* = 0)

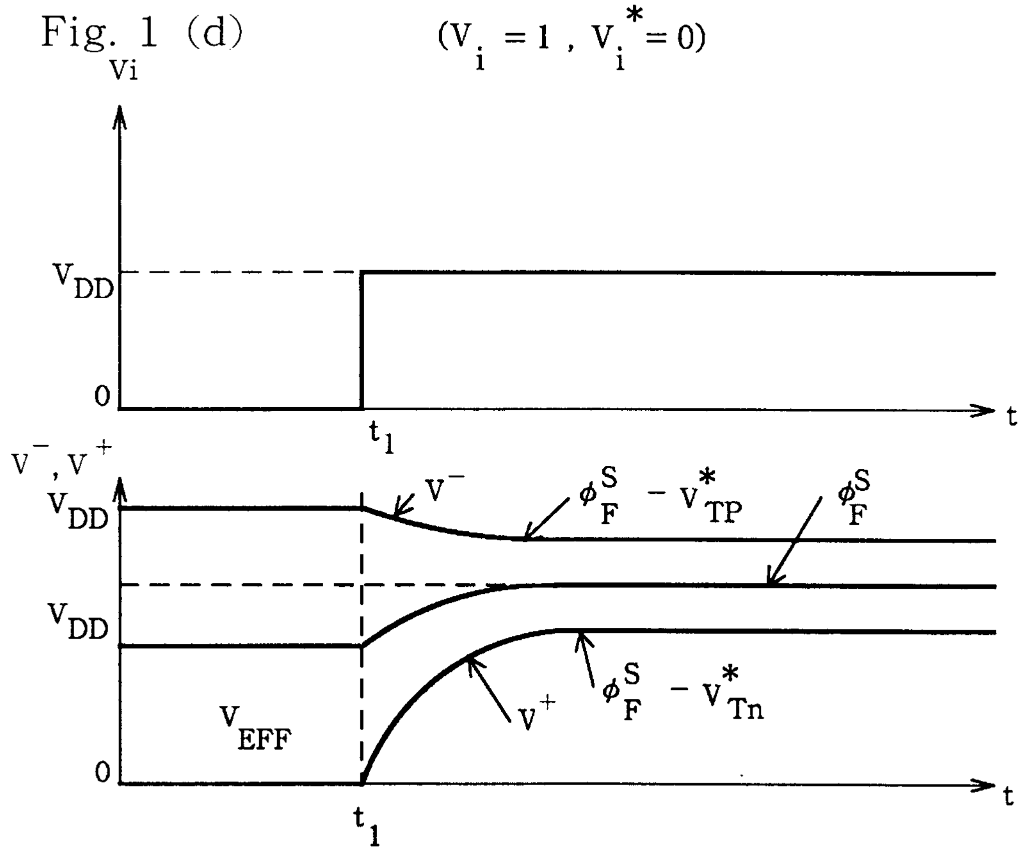

Fig. 1 (e)

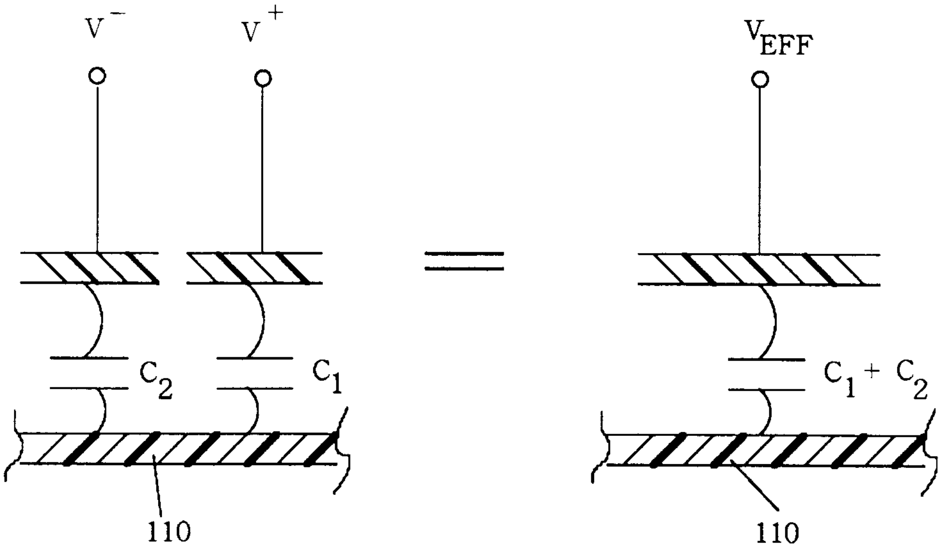


Fig.1 (f)

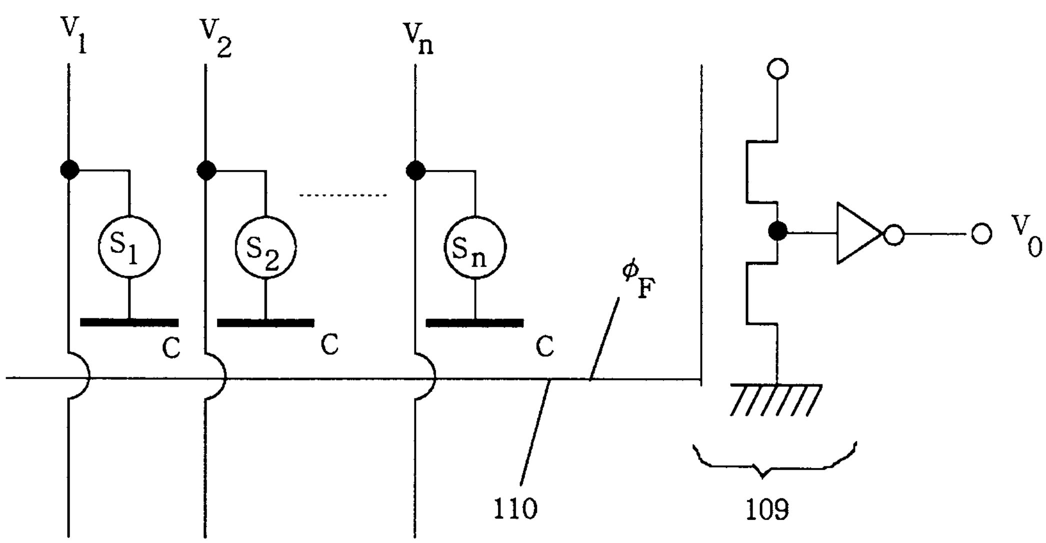

Fig. 1 (g)

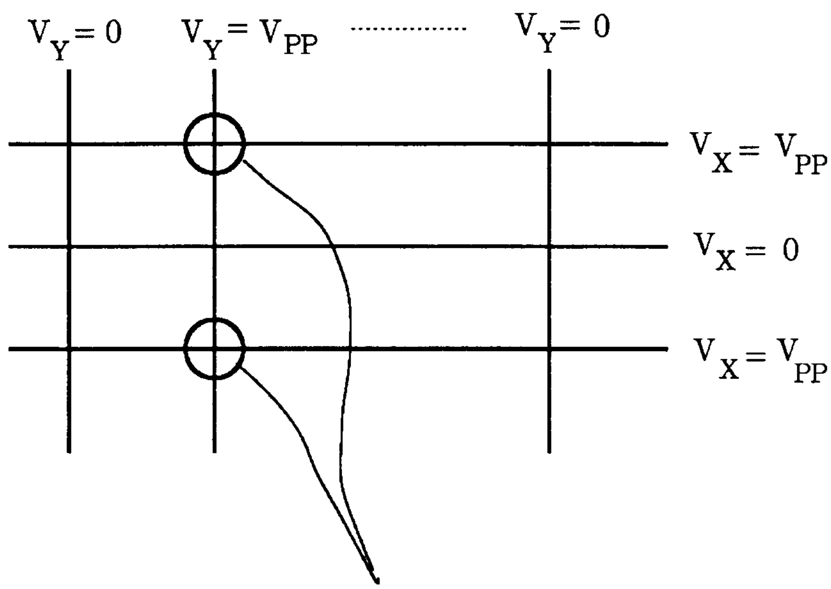


Synapses producing electron implantation (reduction of weight)

Fig. 2

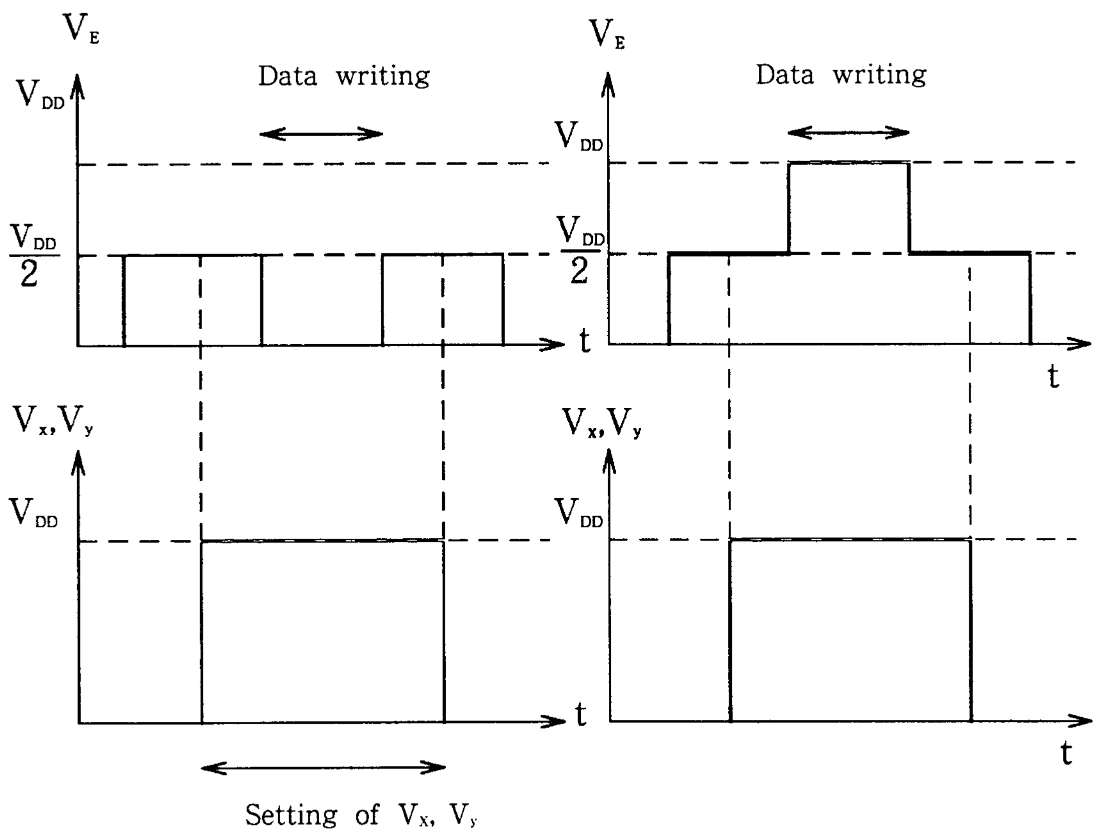


(a) Electron implantation

(b) Electron discharge

Fig. 3

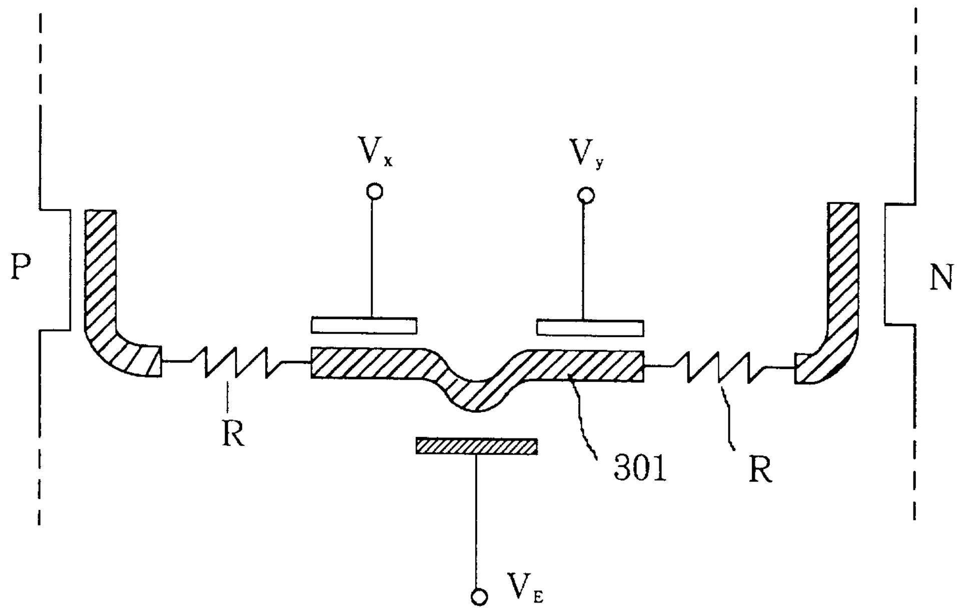

Fig. 4

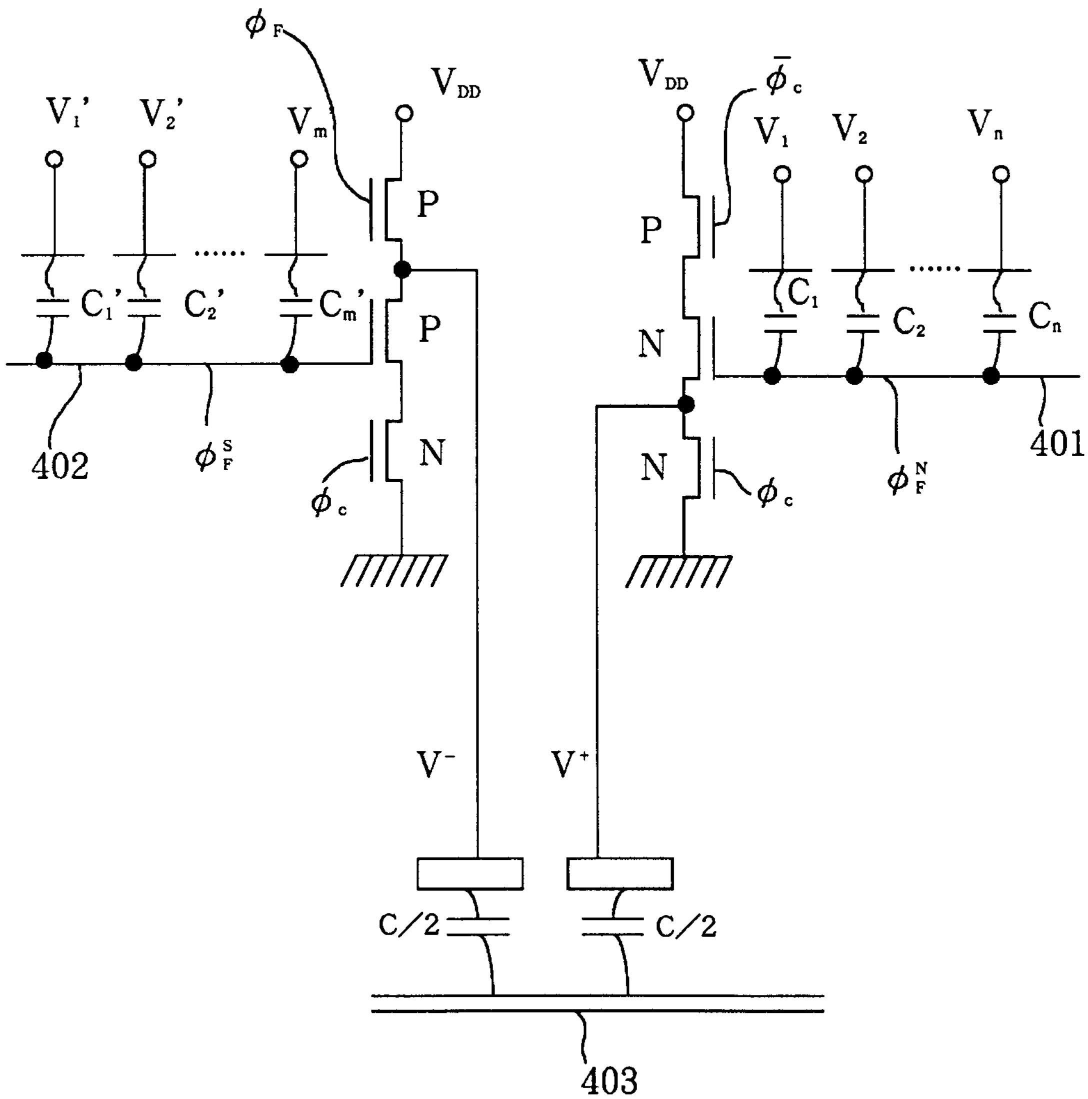

$\phi_F$
$V_{DD}$
$V_1'$
$V_2'$
$V_m$
P
P
N
$C_1'$
$C_2'$
$C_m'$
402
$\phi_F^S$
$\phi_c$
$V_{DD}$
$\bar{\phi}_c$
$V_1$
$V_2$
$V_n$
P
N
N
$C_1$
$C_2$
$C_n$
401
$\phi_c$
$\phi_F^N$
$V^-$
$V^+$
C/2
C/2
403

Fig. 5

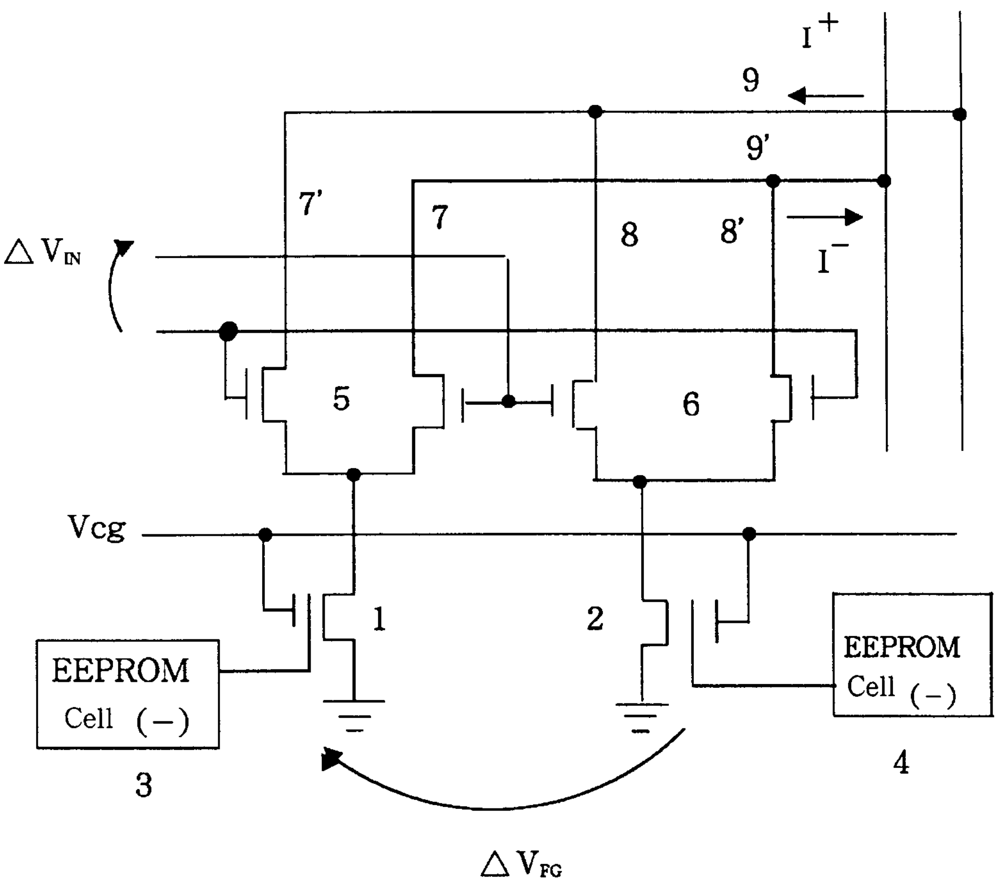

Fig. 6

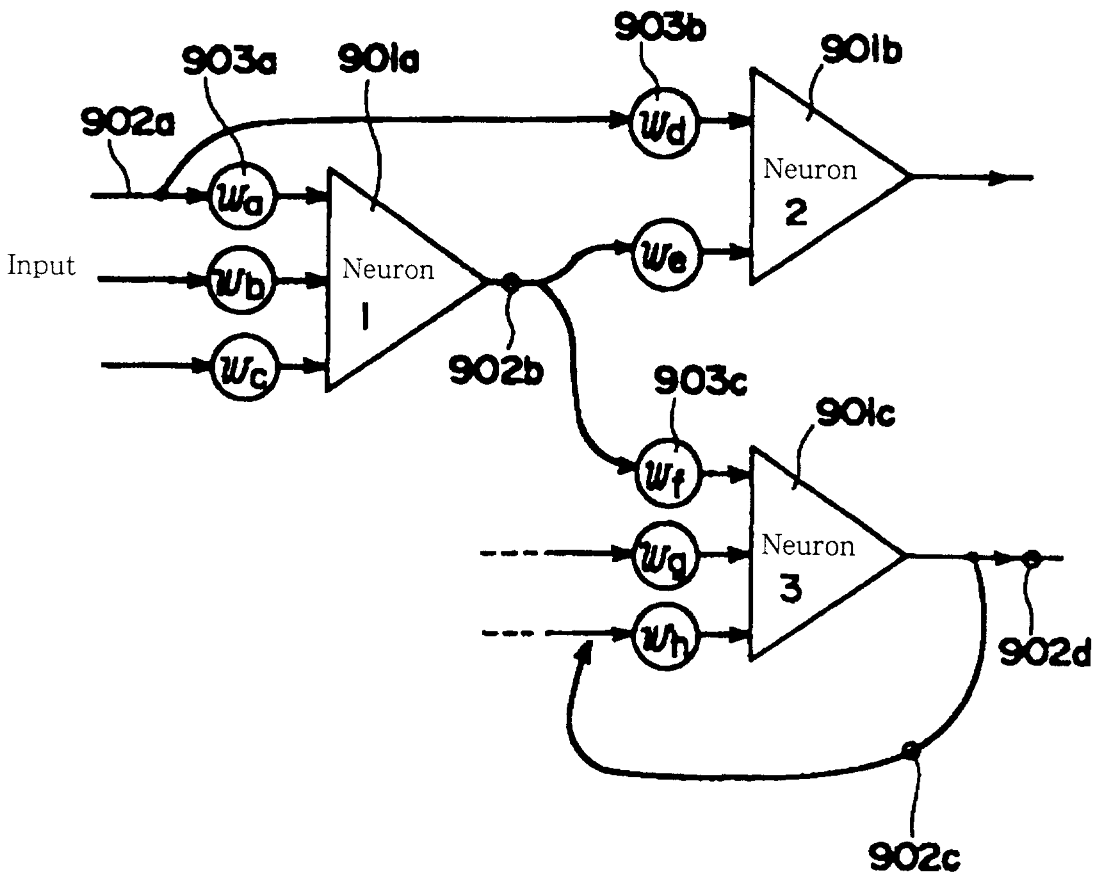
903b
901b
903a
901a
902a
Wd
Wa
Neuron
2
Input
Wb
Neuron
1
We
Wc
902b
903c
901c
Wf
Wg
Neuron
3
Wh
902d
902c

Fig. 7 (a)

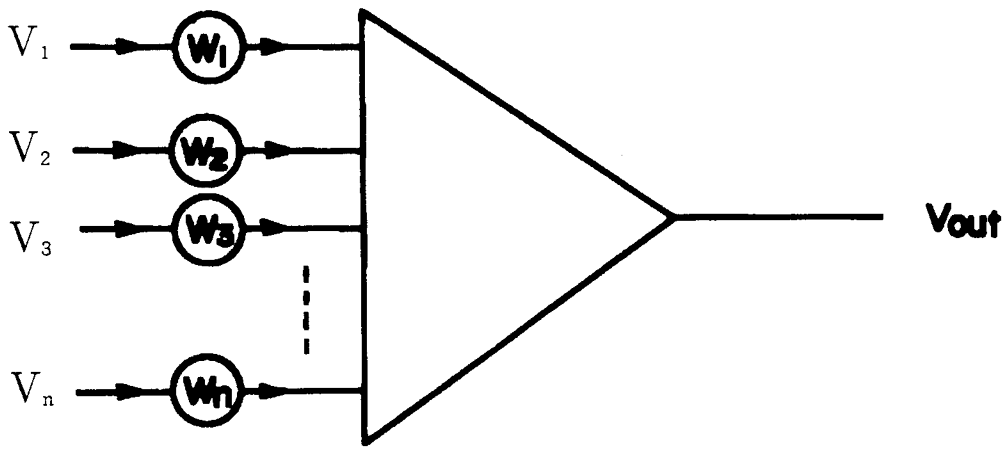


Fig. 7 (b)

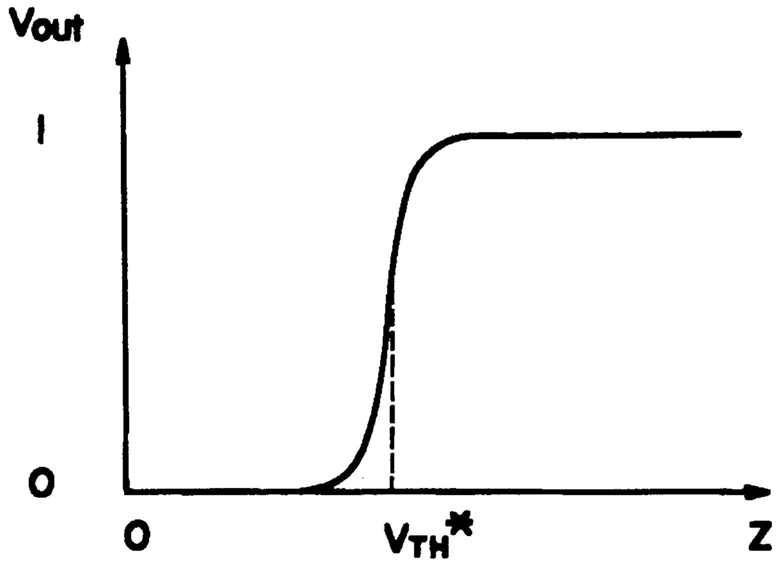


$$Z = \sum_{i=1}^{n} wiVi$$

Fig. 8 (a)

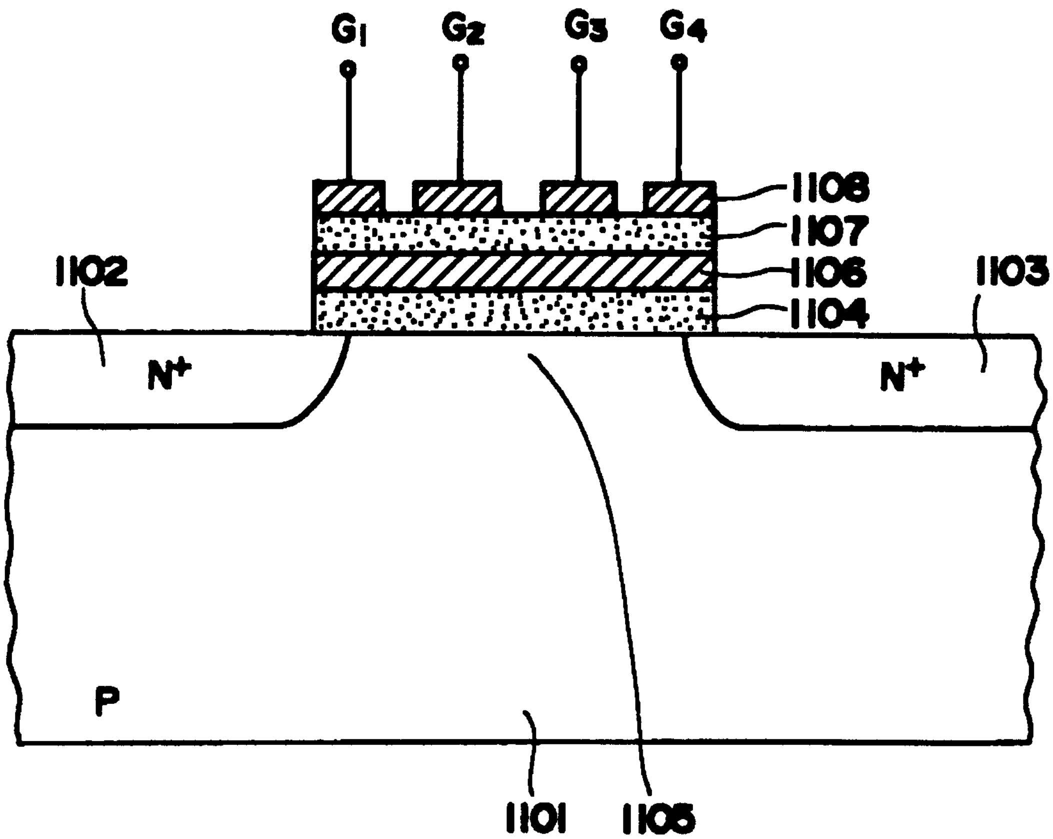

Fig. 8 (b)

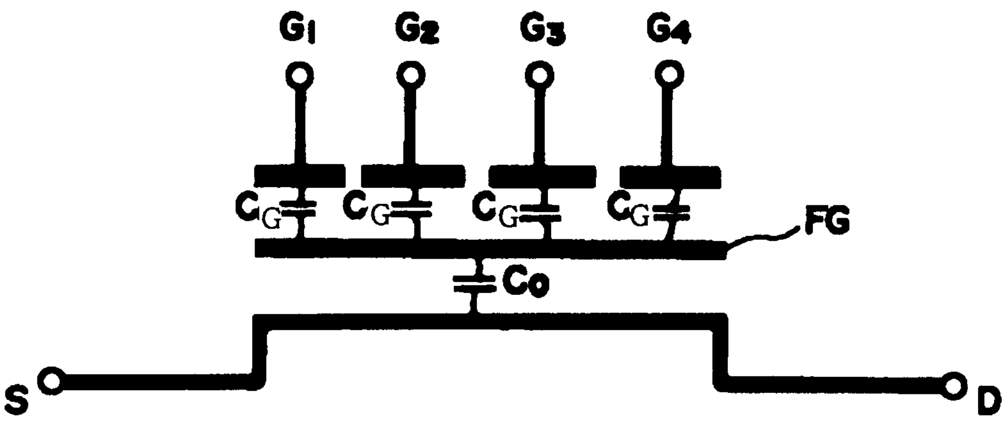

Fig. 8 (c)

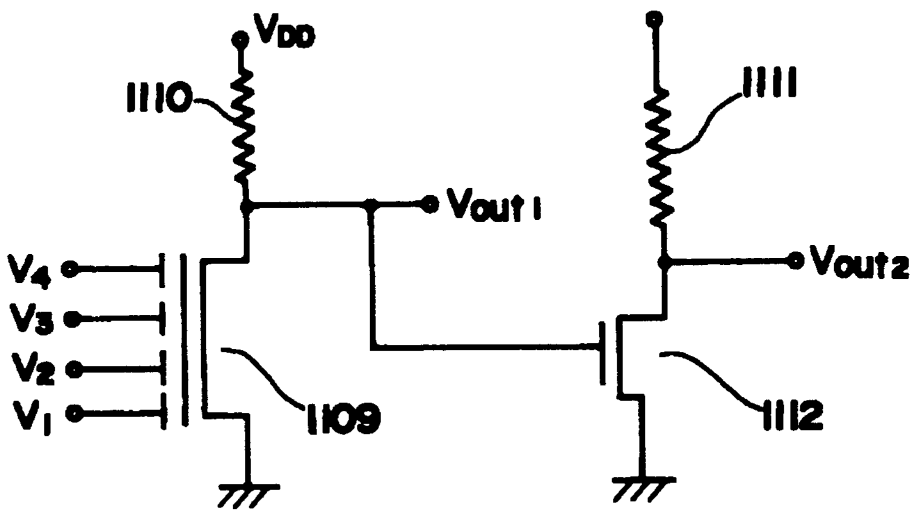

Fig. 8 (d)

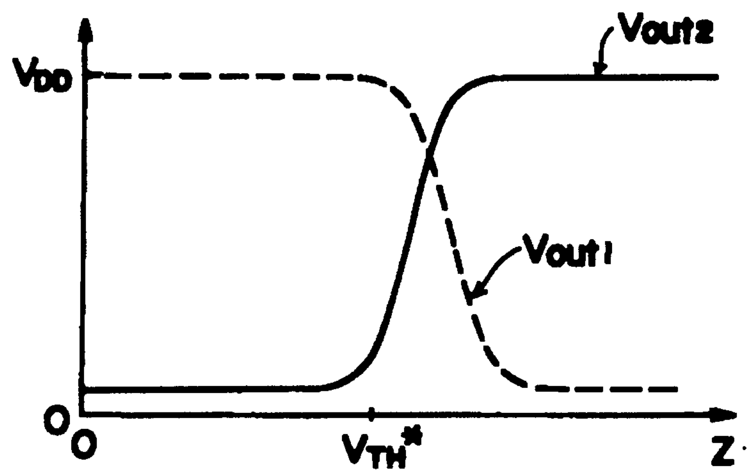

Fig. 9 (a)

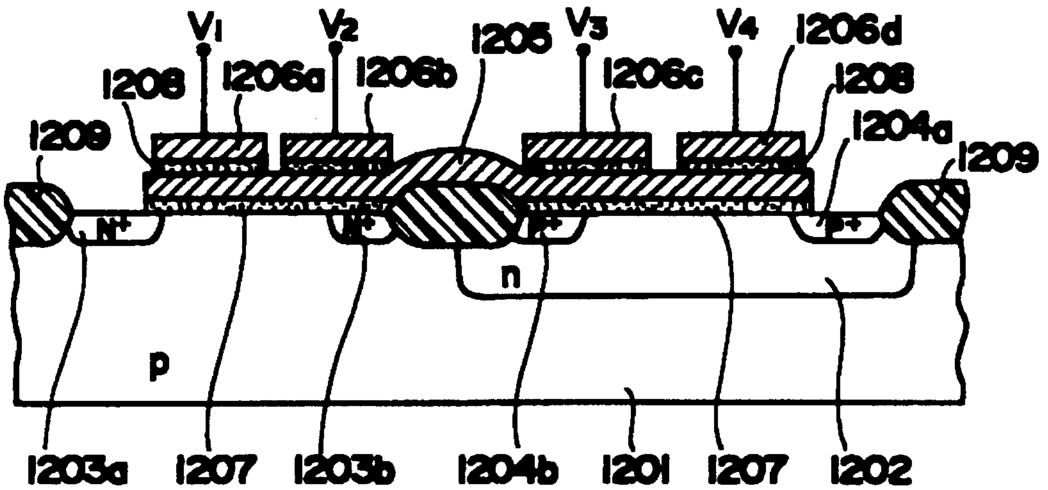
V1
V2
V3
V4
1206d
1205
1208
1206a
1206b
1206c
1208
1209
1204a
1209
N+
N+
P+
P+
n
p
1203a
1207
1203b
1204b
1201
1207
1202

Fig. 9 (b)

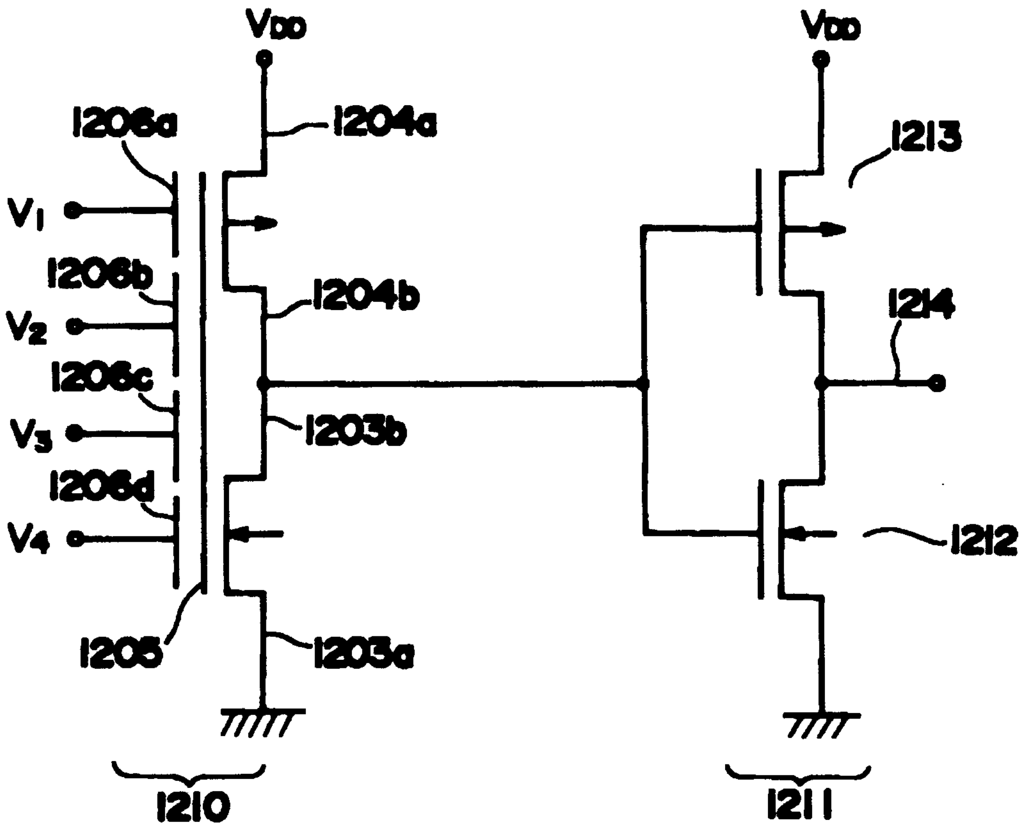
VDD
VDD
1206a
1204a
1213
V1
1206b
1204b
1214
V2
1206c
V3
1203b
1206d
1212
V4
1205
1203a
1210
1211

Fig. 10

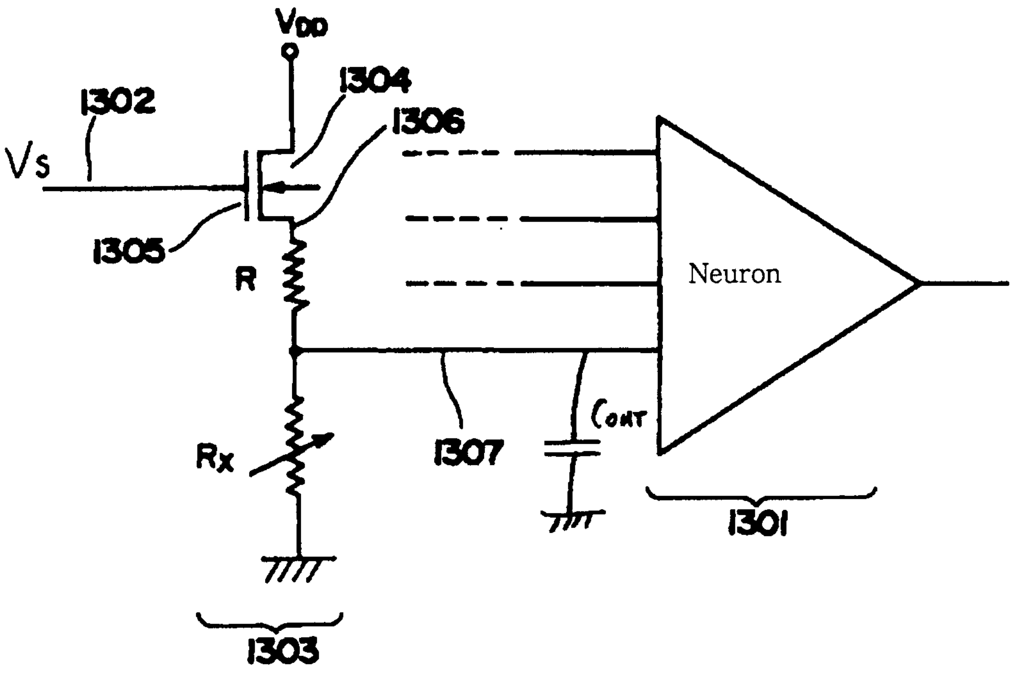

Fig. 11 (a)

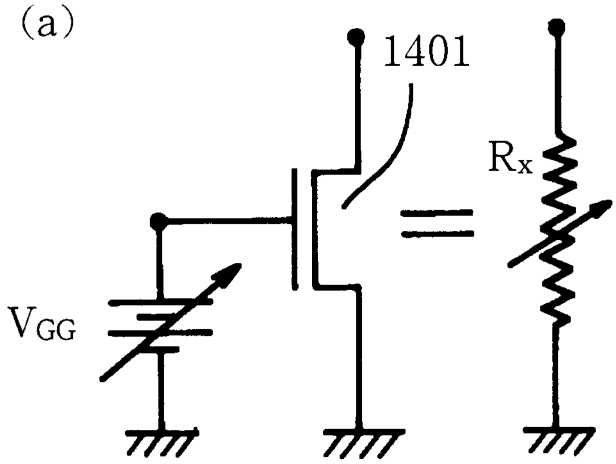


Fig. 11 (b)

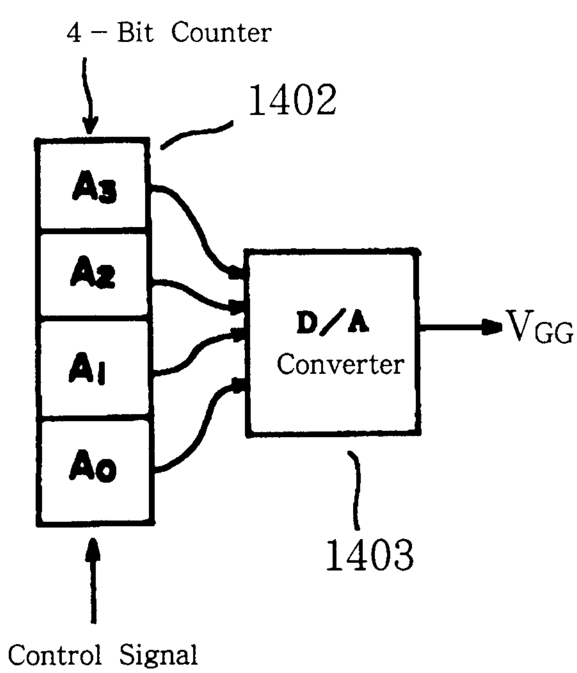

Fig. 12 (a)

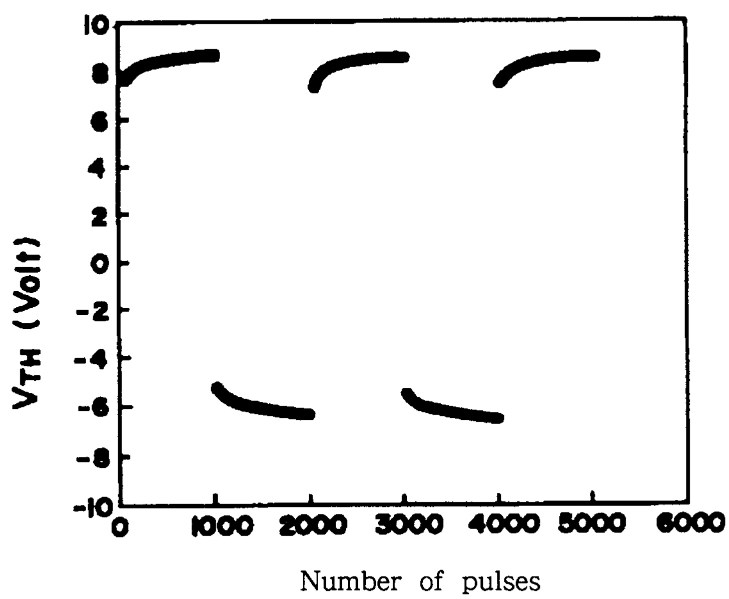


Fig. 12 (b)

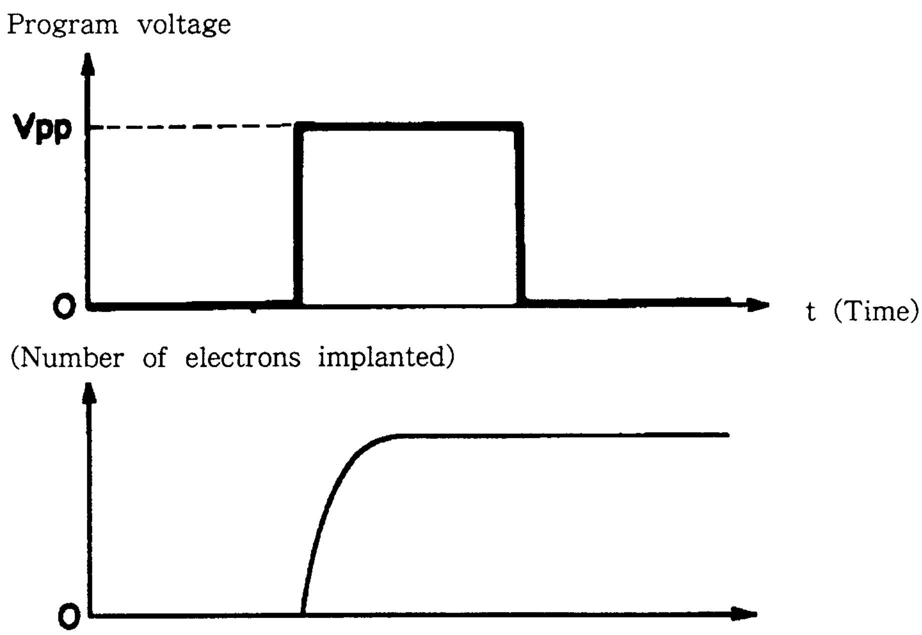

**INTERNATIONAL SEARCH REPORT**

International application No.
PCT/JP93/00750

A. CLASSIFICATION OF SUBJECT MATTER

Int. $Cl^5$ H01L27/10, H01L29/78

According to International Patent Classification (IPC) or to both national classification and IPC

B. FIELDS SEARCHED

Minimum documentation searched (classification system followed by classification symbols)

Int. $Cl^5$ H01L27/10, H01L29/78

Documentation searched other than minimum documentation to the extent that such documents are included in the fields searched

Jitsuyo Shinan Koho 1921 - 1992
Kokai Jitsuyo Shinan Koho 1971 - 1992

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP, A, 3-6679 (Tadashi Shibata), January 14, 1991 (14. 01. 91), Fig. 1 & WO, A1, 9015444 | 1-5 |
| Y | IEEE Transaction on Circuits and Systems, Vol. 38, No. 6, June 1991 (New York, US), Bong W. Lee et al., "Analog Floating-Gate Synapses for General-Purpose VLSI Neural Computation" p. 654-658, Fig. 2 | 1-5 |
| EY | JP, A, 4-271093 (Texas Instruments Inc.), September 28, 1992 (28. 09. 92), (Family: none), Fig. 1 | 1-5 |

[X] Further documents are listed in the continuation of Box C. [ ] See patent family annex.

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| September 8, 1993 (08. 09. 93) | September 28, 1993 (28. 09. 93) |
| Name and mailing address of the ISA/ Japanese Patent Office | Authorized officer |
| Facsimile No. | Telephone No. |